# EUROPEAN PATENT APPLICATION

(11) **EP 3 065 299 A1**
(43) Date of publication of application: **07.09.2016**
(21) Application number: 15461512.4
(22) Date of filing: 04.03.2015
(51) Int. Cl.: H03K 17/96

(54) **A sensor element and a capacitive touch button comprising such a sensor element**

(71) Applicant: Diehl AKO Stiftung & Co. KG, 88239 Wangen (DE)
(72) Inventor: Masina, Pawe, 98-270 Zloczew (PL)
(74) Representative: Holyst, Anna

(57) **Abstract**

The invention relates to a sensor element (1) for a capacitive touch button, comprising a compression spring (2) of an electrically conductive material being in contact with a plate-shaped contact element (3) of the electrically conductive material. The plate-shaped contact element (3) is made of a flexible conductive polymeric or elastomeric material, preferably of a flexible conductive silicone. The invention also relates to a capacitive touch button (4) comprising a touch panel (5) having an upper side (6), on which user's finger is acting, and an underside (7), a printed circuit board (8) which is arranged at a distance beneath the underside of the touch panel (5) and at least one sensor element (1), as described above, which is arranged between the underside (7) of the touch panel (5) and the printed circuit board (8) and it is in an electrically conductive contact with the printed circuit board (8), wherein the plate-shaped contact element (3) of the sensor element (1) is placed such that it faces the underside (7) of the touch panel (5) and the compression spring (2) is in contact with the printed circuit board (8).

## Description

### TECHNICAL FIELD

The present invention relates to a sensor element for a capacitive touch button and a capacitive touch button comprising such a sensor element.

### BACKGROUND ART

Capacitive touch buttons are known and operate on the principle of measuring the change in capacitance (e.g. under a human finger), which can be measured by varying the voltage, current, time of charging/discharging of the capacitance or other methods. Such capacitive touch buttons are used in many electrical/electronic devices, especially in domestic electrical appliances such as cookers, cooktops, microwave ovens, dishwashers, washing machines, etc.

The capacitive touch button usually comprises a touch panel (an insulator) having a top side, on which user's finger is acting, and an underside, a printed circuit board which is arranged at a distance beneath the underside of the touch panel, and a sensor element, disposed between the underside of the touch panel and the printed circuit board.

Different sensor elements for a capacitive touch button are known from the prior art.

A sensor element for a capacitive touch button which has a body of flexible, electrically conductive material is known from the patent US 7,511,242. The sensor element has two walls substantially parallel to each other and facing each other which constitute the top and bottom surfaces and which are integrated into one element by inwardly bent side walls. Such sensor element can be easily compressed.

Capacitive touch buttons are sensitive to an air gap occurring between the upper surface of the sensor element and the insulator which lies above it. If the air gap occurs between the top side of the sensor element and a touch panel, then the capacity drops drastically and press detection is very difficult.

The sensor element of US 7,511,241 is made of a foam material (elastomer or polymer, however silicone and silicone polymers are also suitable). The sensor element made of such material is not resistant to high temperatures. During operation it falls and loses elasticity under the influence of high temperatures and under compression. It also has a tendency to store the shape to which it was compressed. Thus, after compression it may not return to its original shape, and thus it may form an unfavourable air gap.

This tendency to store the shape to which the sensor element was compressed may also be a disadvantage in the event of a breakdown of the device with such sensor element. When the touch panel is demounted and then mounted again, it may prove that a mechanical displacement between the touch panel and the rest of a cooker occurred and an unfavourable air gap appeared.

Consequently, during operation of the device comprising such sensor element a gap may occur between the upper surface of the sensor element and the underside of the touch panel, which gap reduces the sensitivity of the capacitive touch button.

Additionally, due to the fact that the sensor element of a foam material falls during operation it must be relatively strongly compressed at the beginning, thus exerting a high pressure on the printed circuit board. Such pressures on the PCB are also unfavourable.

Another problem connected with the sensor element of US 7,511,241 is a method of its mounting on the PCB. The most preferred method of assembling components on the PCB is soldering, while the sensor element of US 7,511,241 is usually glued to the PCB. The gluing of such components to the PCB is an expensive and time-consuming process. Replacement of such sensor elements is also difficult.

Furthermore, the material of which the sensor element of US 7,511,241 is made is opaque, which prevents highlighting of the capacitive touch button.

In another solution known from the prior art, the sensor element has the form of spring with a circular metal plate at one end thereof. As was already mentioned above, capacitive touch buttons are sensitive to the air gap between the upper surface of the sensor element and the touch panel. A top plate (glass or ceramic) of cookers usually has a thickness of approximately 4 mm and it has a structure with bulges on the underside, which causes, in the case of using a spring with a metal plate, the formation of air gaps and reduction of key sensitivity.

Furthermore, a circular metal plate in the above-mentioned sensor element also has a production gap on its surface facing in the direction of the touch panel, when installed in a capacitive touch button, formed when the spring is mounted to the plate. This gap also results in an unfavourable air gap that occurs in the place of the user's finger touch. This sensor element entirely made of metal also does not allow highlighting of the capacitive touch button.

Furthermore, the mounting of the sensor element with a fixed metal plate is not possible in the case the user interface has rounded shapes. Then the spring is used alone (without a metal plate) and layers of a conductive ink are applied on the underside of the touch panel in the area of keys, which is expensive and time consuming.

### Summary of the Invention

The purpose of the present invention is to provide a sensor element for a capacitive touch button which eliminates the above mentioned drawbacks of the prior art solutions.

The purpose of the present invention is to provide a sensor element for a capacitive touch button that provides improved detection of the user's finger touch, i.e. a better contact between the sensor element and the touch panel by eliminating the air gap between the sensor element and the touch panel (insulator) arranged above it, from the beginning of installation of the sensor element in the capacitive touch button and during the entire operation of the capacitive touch button.

The purpose of the present invention is to provide a sensor element for a capacitive touch button which has more advantageous properties for mounting thereof in the capacitive touch button than the known solutions.

The purpose of the invention is also to provide a solution of the sensor element which is simple in construction and inexpensive to manufacture.

The purpose of the invention is to provide a sensor element for a capacitive touch button resistant to high temperatures. The purpose of the invention is to provide a sensor element for a capacitive touch button, which provides a possibility to illuminate the button (to highlight the button). The purpose of the invention is to provide a capacitive touch button comprising a sensor element which fulfils the above purposes.

These purposes are achieved by means of a sensor element having the features defined in claim 1 and a capacitive touch button having the features defined in claim 8. Preferred and advantageous features of the present invention are defined in the dependent claims.

The above-mentioned purposes are solved by the sensor element for a capacitive touch button according to the invention, comprising a compression spring of electrically conductive material being in contact with the plate-shaped contact element made of electrically conductive flexible polymeric or elastomeric material, preferably of a flexible conductive silicone.

The combination of the metal spring and the plate-shaped contact element of an elastic, electrically conductive polymeric or elastomeric material, in particular silicone, forms an innovative sensor element which has many advantages as compared to the known solutions.

Specifically, such a combination results in a sensor element which fully and during the whole operation life of the capacitive touch button ensures a reliable contact between the sensor element and the touch panel without the presence of a disadvantageous air gap in the capacitive touch button, and thus it ensures the proper operation of the touch button during the entire operation life thereof. The plate-shaped contact element of a flexible, electrically conductive polymeric or elastomeric material adapts to any irregularities (e.g. bubbles) of the touch panel or interface with rounded shapes, while the spring, through its elasticity, always allows a tight fit of the plate-shaped contact element to the underside of the touch panel, which ensures proper operation of the button during the its whole operation life. Also, in the event of any repairs and dismounting of the plate, the spring together with the conformable plate-shaped element ensure continued proper operation of the button after the reassembly. The spring and the contact element of flexible, electrically conductive (non-porous) silicone are resistant to high temperatures, which is important, especially for use in cookers.

The plate-shaped contact element made of a non-foamed silicon is also cheaper than the silicone foam used in the known solutions and the spring used is simple and cheap in production.

Furthermore, the plate-shaped contact element made of a transparent or partially transparent silicone provides the possibility of illuminating/ highlighting the capacitive touch button, which is not provided for in the above-mentioned solutions of the prior art.

One important advantage of the sensor element according to the invention is also that it is suitable for soldering. As mentioned in the description of the prior art, soldering is the most preferred method of mounting components on the PCB. The sensor element according to the invention is suitable for soldering; it can be mounted on a printed circuit board by means of both Through-Hole Technology (THT) and Surface Mount Technology (SMT). Especially for Through-Hole Technology the compression spring can comprise a free folded down end. The area of attachment of the sensor element on the circuit board is smaller than the surface area of the plate-shaped silicone contact element (which allows for a more effective use of the available place on a PCB). Furthermore, the solution in which the compression spring is detachably connected to the plate-shaped contact element ensures an easy and precise mounting of the spring on the printed circuit board. Also, the presence of a clip during SMT mounting ensures easy and precise mounting.

Thus, the sensor element according to the invention is simple in construction and inexpensive to produce, because it is based on a combination of two low-cost technologies (a metal spring plus a plate-shaped element of flexible, conductive silicon) while maintaining all the necessary functional characteristics of the capacitive touch button during entire operation life thereof.

The capacitive touch button usually comprises more than one sensor element. In this case, the preferred solution is to embed the plate-shaped contact elements of the sensor elements in a non-conductive supporting sheet or to mount a plurality of plate-shaped contact elements to a non-conductive supporting sheet.

### Brief description of the Drawings

Further characteristics and advantages of the invention will become apparent from the following description which is given in examples of specific non-limiting embodiments, with reference to the accompanying drawings, in which:
Fig. 1 shows a side view of a sensor element according to the invention,
Fig. 2 shows a side view of a first embodiment of a capacitive touch button according to the invention, in which the sensor element is mounted on the printed circuit board by means of the Through-Hole Technology (THT),
Fig. 3 shows a side view of a second embodiment of a capacitive touch button according to the invention, in which the sensor element is mounted on the printed circuit board by means of the Surface Mount Technology (SMT),
Fig. 4 shows a side view of a third embodiment of a capacitive touch button according to the invention, in which the sensor element is mounted on the printed circuit board by means of a SMD (Surface Mount Devices) clip soldered to the printed circuit board,
Fig. 5 shows a side view of a fourth embodiment of a capacitive touch button according to the invention highlighted by one LED,
Fig. 6 shows a side view of a fifth embodiment of a capacitive touch button according to the invention highlighted by two LEDs,
Fig. 7 shows a side view of a sixth embodiment of a capacitive touch button comprising a plurality of sensor elements with plate-shaped contact elements embedded in a non-conductive supporting sheet, and
Fig. 8 shows a side view of a seventh embodiment of a capacitive touch button comprising a plurality of sensor elements with plate-shaped contact elements attached to a non-conductive supporting sheet.

### Detailed Description of the Embodiments

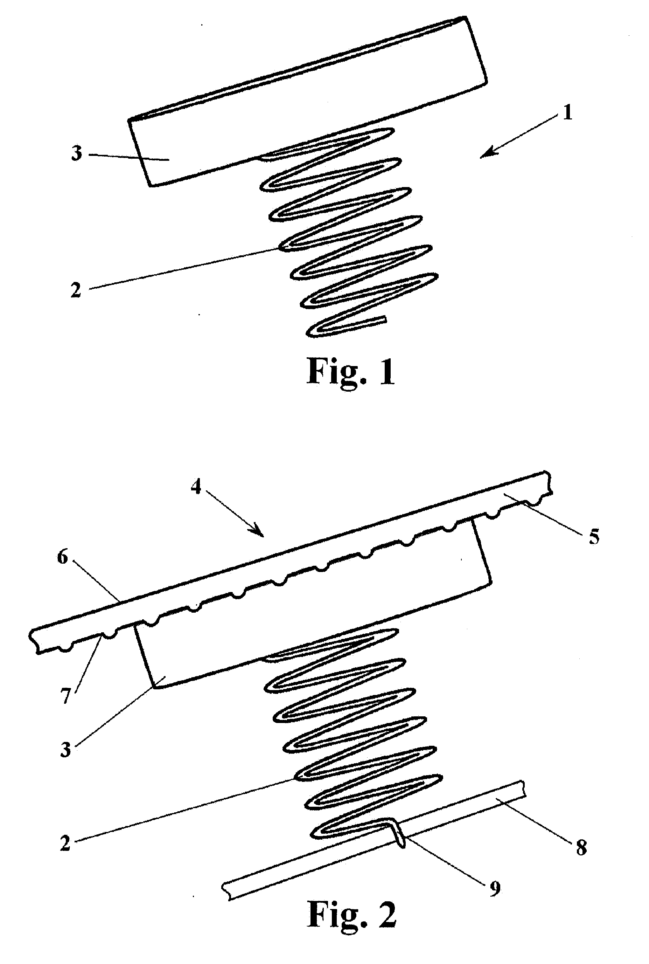

Fig. 1 shows a side view of a sensor element 1 according to the invention for a capacitive touch button. The sensor element 1 comprises a compression spring 2 of electrically conductive material, usually metal, being in contact with the plate-shaped contact element 3 of electrically conductive material such that the compression spring 2 is in electrically conductive contact with the plate-shaped contact element 3.

According to the invention, the plate-shaped contact element 3 is made of a conductive polymeric or elastomeric material, and preferably of a flexible conductive silicone. The flexible conductive silicon adapts to the structure of a ceramic pane (glass/glass pane) or to a plastic plate commonly used as a touch panel in the capacitive touch buttons, in particular a plate provided with bulges on its underside, as shown in fig. 2, whereas the spring 2, through its elasticity, allows always tight fit of the plate-shaped contact element 3 to the underside of the touch panel, which ensures proper operation of the button during its whole operation life. Also, in the event of any repairs of the device and dismounting of the plate, the spring together with the conformable plate-shaped element ensure continued proper operation of the button after the assembly. The spring and the contact element of flexible, electrically conductive (non-porous) silicone are resistant to high temperatures, which is important, especially for use in cookers.

The plate-shaped contact element 3 may be made of a non-foamed silicone, which is cheaper than the foamed silicone used in the solutions known from the prior art. The plate-shaped contact element 3 may have any shape, for example similar to a disc or a rectangular or square plate. The plate-shaped contact element 3 may be made of a conductive polymeric or elastomeric material, preferably silicone, which may be opaque, transparent or partially transparent. Silicone that is transparent or partially transparent enables illumination of a capacitive touch button.

The plate-shaped contact element 3 may only be in contact with the compression spring 2 or may be permanently or detachably connected to the compression spring 2. A permanent connection between those elements may be made, for example, by embedding the compression spring 2 in the plate-shaped contact element 3. A releasable connection between these elements may be carried out, for example, as a press-in or screwed connection. Embedding is carried out at the silicone production stage, specifically, during its curing, whereas the second method may be carried out by manual screwing, similar to fastening a screw, on the production line after the exit of a printed circuit board from a soldering furnace. A releasable connection is advantageous from a manufacturing point of view since it is preferable to attach the spring to the printed circuit board at the stage of soldering components on a printed circuit board.

Both the dimensions of the plate-shaped.contact element 3, i.e. its thickness and length and width (if it has a rectangular shape) or diameter (in the case it has a circular shape), as well as the dimensions of the compression spring 2, i.e. its diameter and height, will be selected according to the requirements of a particular application.

The sensor element 1 according to the invention is simple in construction and cheap to manufacture, since it is based on a combination of two low-cost technologies (a spring plus flexible conductive silicon), while providing all the necessary functional features for a capacitive touch button comprising the sensor element according to the invention.

The sensor element 1 is located in a capacitive touch button 4.

The capacitive touch button 4 comprises a touch panel 5 having an upper side 6, on which user's finger is acting, and an underside 7, a printed circuit board 8 which is arranged at a distance beneath the underside of the touch panel 5 and the above-described at least one sensor element 1 according to the invention, which is arranged between the underside 7 of the touch panel 5 and the printed circuit board 8 and it is in an electrically conductive contact with the printed circuit board 8, wherein the plate-shaped contact element 3 of the sensor element 1 is placed such that it faces the underside 7 of the touch panel 5, and the compression spring 2 is in contact with the printed circuit board 8.

Figures 2, 3 and 4 show different mounting methods of the sensor element 1 in the capacitive touch button 4.

Thus, fig. 2 shows a side view of a first embodiment of the capacitive touch button 4 according to the present invention, wherein the sensor element 1 is mounted on a printed circuit board 8 by the Through-Hole Technology (THT). To this end, the free end 9 of the compression spring 2 of the sensor element 1, i.e. the end opposite to that on which the plate-shaped contact element 3 is mounted, is provided with a downwardly bent vertical section, which is used to attach the compression spring 2 to the printed circuit board 8 by means of the Through-Hole Technology (THT) known in the state of the art.

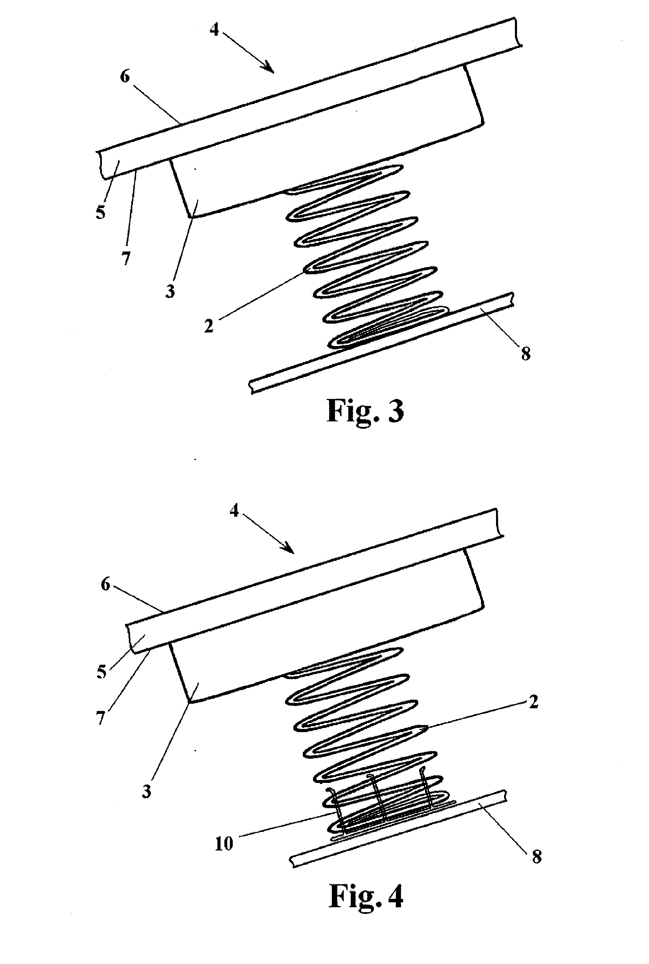

With reference to fig. 2, there is shown a touch panel 5 having a shape of a plate with bulges on its underside 7. It can be seen in this figure that the flexible plate-shaped contact element 3, preferably made of flexible, conductive silicon, adapts to the bulges on the underside 7 of the touch panel 5, thus eliminating air gaps and increasing the sensitivity of the capacitive touch button 4. Obviously, the touch panel 5 may have substantially a smooth underside 7, as well as the plate with bulges on the underside 7 may be used in any of the embodiments of the capacitive touch button 4 shown in figures 3 - 8.

Figs. 3 and 4 show, in a side view, a second and a third embodiment of the capacitive touch button 4 of the present invention, wherein the sensor element 1 is mounted on a printed circuit board 8 by means of the known surface mount technology (SMT), wherein in the example of fig. 3 the compression spring 2 is soldered to the printed circuit board 8, and in the embodiment of fig. 4 the compression spring 2 is mounted by a SMD clip 10 soldered to the printed circuit board 8. The spring in this example is clinging/latched on the SMD clip.

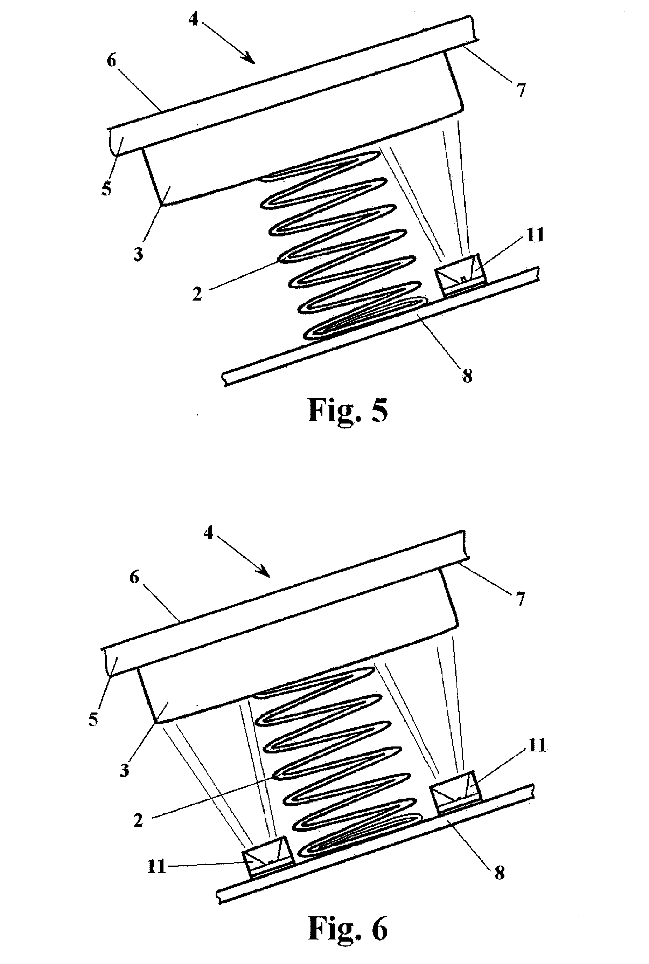

Figs. 5 and 6 show, in a side view, a fourth and a fifth embodiment of the capacitive touch button 4 of the present invention. In these embodiments, the capacitive touch button 4 comprising a touch panel 5, a printed circuit board and a sensor element 1 according to the invention arranged between them, comprises at least one illuminating element 11 mounted on the printed circuit board 8 close to the compression spring 2 and highlighting the touch panel 4. Preferably, the at least one illuminating element 11 is a LED. Obviously, in these embodiments, the touch panel 5 and the plate-shaped contact element 3 are transparent or partially transparent. Fig. 5 illustrates an embodiment of the capacitive touch button provided with one illuminating element 11, and fig. 6 illustrates an embodiment of the capacitive touch button provided with two illuminating elements 11.

It should be emphasized however that the spring must be electrically connected to the PCB, while the mechanical connection between these components is optional. Thus, a usual contact between these elements is also possible. This can be accomplished, for example, by means of a known non-conductive supporting frame equipped with grips, in which the springs of sensor elements are inserted.

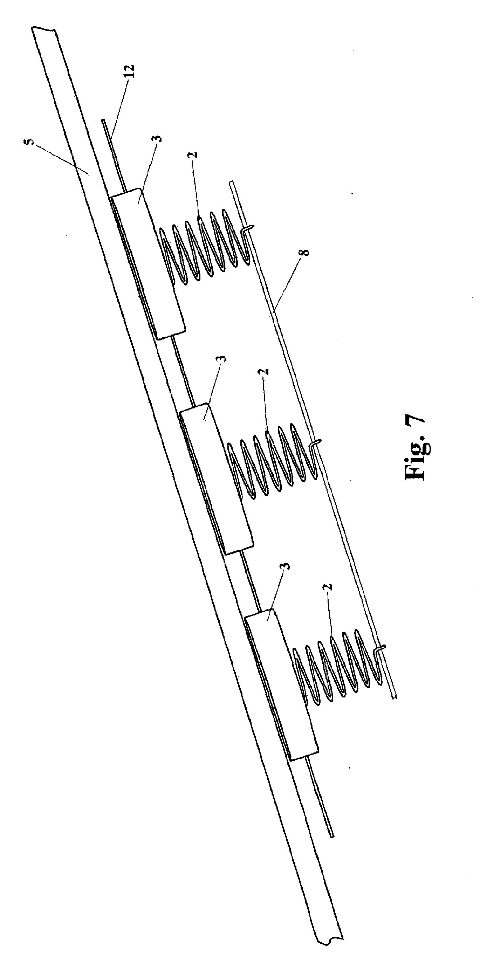

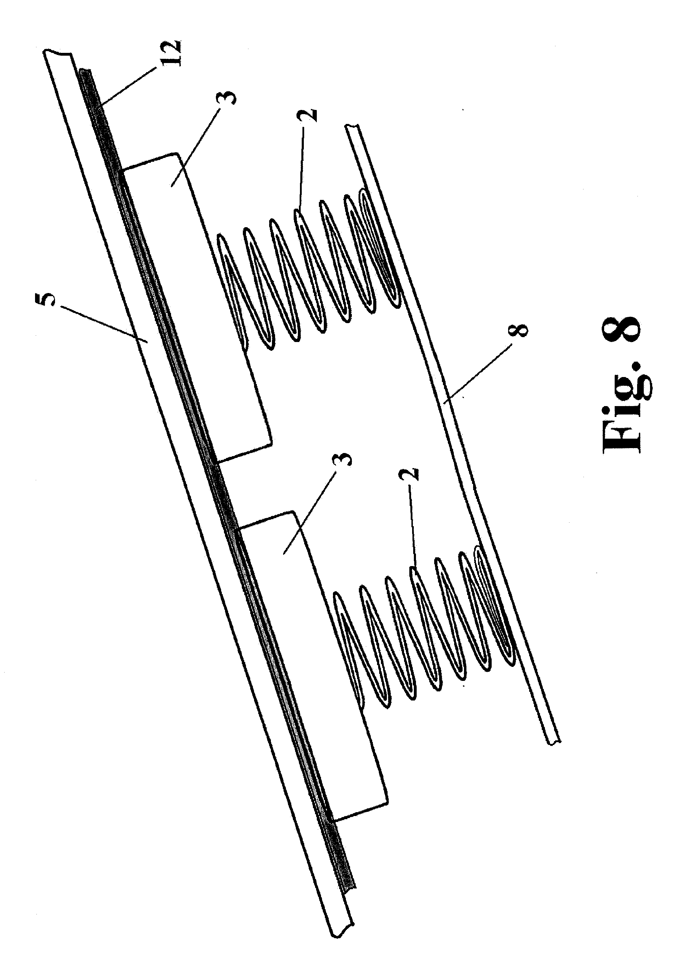

The capacitive touch button can comprise more than one sensor element. In this case, it is preferable to embed the plate-shaped contact elements 3 of these sensor elements in a non-conductive supporting sheet 12 as shown in fig. 7. This non-conductive supporting sheet 12 may be preferably made of, for example, non-conductive silicone. Another possibility is to attach a plurality of plate-shaped contact elements 3 to a non-conductive supporting sheet 12, made of non-conductive plastic film, a non-conductive net or the like, as shown in fig. 8. This attachment can be done, for example, by gluing.

The various disclosed above solutions and methods for connecting elements of the capacitive touch button can be combined with each other or used interchangeably depending on the needs of a particular solution.

The present invention is not limited to the above-described embodiments and the accompanying drawings, whereas the scope of the protection is defined by the appended claims.

### Reference numbers in the drawings

1 - sensor element
2 - compression spring
3 - plate-shaped contact element
4 - capacitive touch button
5 - touch panel
6 - upper side (of the touch panel 5)
7 - underside (of the touch panel 5)
8 - printed circuit board
9 - bent end (of the compression spring 2)
10 - SMD clip
11 - illuminating element
12 - non-conductive supporting sheet

## Claims

1. A sensor element (1) for a capacitive touch button comprising a compression spring (2) of an electrically conductive material being in contact with a plate-shaped contact element (3) of an electrically conductive material, **characterized in that** the plate-shaped contact element (3) is made of a flexible conductive polymeric or elastomeric material.

2. The sensor element according to claim 1, **characterized in that** the plate-shaped contact element (3) is made of a flexible conductive polymeric or elastomeric material that is transparent, partially transparent or opaque.

3. The sensor element according to claim 1 or 2, **characterized in that** the plate-shaped contact element (3) is made of a flexible conductive silicone.

4. The sensor element according to claim 3, **characterized in that** the plate-shaped contact element (3) is made of a non-foamed silicone.

5. The sensor element according to any one of the preceding claims, **characterized in that** the compression spring (2) is connected to the plate-shaped contact element (3) in a permanent manner.

6. The sensor element according to any one of the claims 1-4, **characterized in that** the compression spring (2) is detachably connected to the plate-shaped contact element (3).

7. The sensor element according to any of the preceding claims, **characterized in that** the plate-shaped contact element (3) has a shape similar to a disc or a rectangular or square plate.

8. A capacitive touch button (4) comprising
a touch panel (5) having an upper side (6), on which user's finger is acting, and an underside (7);
a printed circuit board (8) which is arranged at a distance beneath the underside of the touch panel (5); and
at least one sensor element (1) according to any one of claims 1-7, which is arranged between the underside (7) of the touch panel (5) and the printed circuit board (8) and it is in an electrically conductive contact with the printed circuit board (8), wherein the plate-shaped contact element (3) of the sensor element (1) faces the underside (7) of the touch panel (5) and the compression spring (2) is in contact with the printed circuit board (8).

9. The capacitive touch button according to claim 8, **characterized in that** the sensor element (1) is mounted on the printed circuit board (8) by means of one of the following methods: Through-Hole Technology (THT), Surface Mount Technology (SMT), SMD clip (10) soldered to the printed circuit board (8), wherein the compression spring (2) is clinging/ latched on the SMD clip (10), or by means of a non-conductive supporting frame with grips for the springs.

10. The capacitive touch button according to claim 8 or 9, **characterized in that** it comprises more than one sensor element (1), wherein the plate-shaped contact elements (3) of the sensor elements (1) are embedded in a non-conductive supporting sheet (12).

11. The capacitive touch button according to claim 8 or 9, **characterized in that** it comprises more than one sensor element (1), wherein the plate-shaped contact elements (3) of the sensor elements (1) are attached to a non-conductive supporting sheet (12).

12. The capacitive touch button according to any one of claims 8-11, **characterized in that** at least one illuminating element (11) which provides highlighting of the touch panel (5), which panel is transparent or partially transparent, is arranged at the printed circuit board (8), close to the compression spring (2), and the plate-shaped contact element (3) is transparent or partially transparent.

13. The capacitive touch button according to claim 12, **characterized in that** the at least one illuminating element 11 is a LED.
